(19) Europäisches Patentamt
European Patent Office
Office européen des brevets

(11) **EP 4 760 391 A1**

(12) **EUROPEAN PATENT APPLICATION**

(43) Date of publication:
**17.06.2026 Bulletin 2026/25**

(21) Application number: **24220110.1**

(22) Date of filing: **16.12.2024**

(51) International Patent Classification (IPC):
**$G03F\ 7/00$** $^{(2006.01)}$

(52) Cooperative Patent Classification (CPC):
**G03F 7/70633; G03F 7/70458**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **HSU, Chia-Hao**
  **5500 AH Veldhoven (NL)**
• **HAVIK, Niels**
  **5500 AH Veldhoven (NL)**
• **BRINKHOF, Ralph**
  **5500 AH Veldhoven (NL)**
• **WERKMAN, Roy**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD AND APPARATUS FOR CORRECTING PROCESSES RELATED TO BONDED SUBSTRATES**

(57)    A method that comprises determining a dynamic common grid based on a location of structures at a bonding interface of a bonded substrate and/or obtaining target substrate distortion data associated with a second substrate that is to be bonded to a first substrate to obtain the bonded substrate. The dynamic common grid and/or target substrate distortion data is used in determining at least a first control action for exposing the first substrate, wherein the control action balances at least first substrate overlay and bonding overlay.

Fig. 4

**Description**

BACKGROUND

Field of the Invention

The present invention relates to a method and apparatus for bonding two or more substrates together, and in particular methods and apparatuses for improving performance of the process of manufacturing bonded substrates.

Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.
In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.
Examples of known scatterometers include angle-resolved scatterometers of the type described in US2006033921A1 and US2010201963A1. The targets used by such scatterometers are relatively large, e.g., 40$\mu$m by 40$\mu$m, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.
Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.
It would be desirable to improve process control methods in the manufacture of integrated devices using bonded substrate techniques.

SUMMARY OF THE INVENTION

In a first aspect of the invention, there is provided a method of configuring at least a first lithographic apparatus for performing a first lithographic process on at least a first substrate which is to be bonded to a second substrate to obtain a bonded substrate, the method comprising: determining a dynamic common grid based on a location of structures at a bonding interface of the bonded substrate, the dynamic common grid comprising a control grid which is common for said first lithographic process and a second lithographic process on the second substrate prior to said bonding; and/or obtaining target substrate distortion data associated with the second substrate that is to be bonded to the first substrate or which comprises said dynamic common grid; and using said dynamic common grid and/or said target substrate distortion data in determining at least a first control action for performing at least the first lithographic process, wherein the control action balances at least first substrate overlay relating at least to a misalignment between a first bonding layer of the first substrate and at least one previous layer of the first substrate and bonding overlay relating to a misalignment between the first bonding layer and a second bonding layer on the second substrate after bonding of the first substrate to the second substrate.

In a second aspect of the invention, there is provided a method of configuring at least a first manufacturing apparatus for exposing a first layer on a substrate, onto which at least a second layer is to be exposed using a second manufacturing apparatus, the first manufacturing apparatus having a first actuation capability and the second first manufacturing apparatus having a second actuation capability, the method comprising: obtaining target substrate distortion data describing distortion which cannot be corrected or can be only partially corrected with the second actuation capability; and determining at least a first control action for exposing the first layer using said target substrate distortion data.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for semiconductor devices;

Figure 2 is a flow diagram describing an existing method of manufacturing integrated devices which utilizes wafer-to-wafer bonding;

Figure 3(a) illustrates a bonded wafer, comprising a number of layers per constituent wafer, where each constituent wafer is referenced to a respective different wafer grid and Figure 3(b) illustrates the same bonded wafer refenced to a dynamic common grid.

Figure 4(a) and Figure 4(b) respectively illustrate two steps in determining a correction for the bonded wafer and dynamic common grid illustrated in Figure 3(b);

Figure 5 illustrates a bonded wafer and correction strategy based on sparse bonded alignment data supplemented with bonded overlay data; and

Figure 6 is a flowchart of a method of determining control trajectories for exposing a wafer according to methods disclosed herein.

DETAILED DESCRIPTION

Before describing embodiments of the invention in detail, it is instructive to present an example environment in which embodiments of the present invention may be implemented.

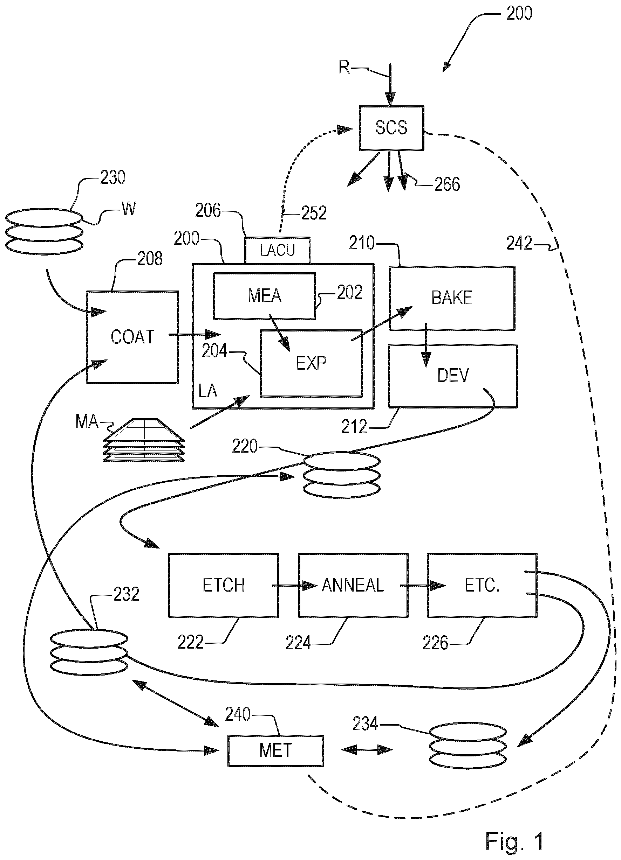

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may be for example of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

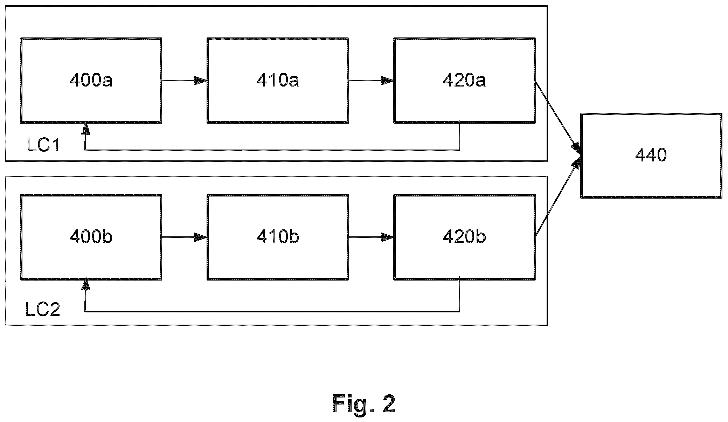

Figure 2 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 400a, 400b and first metrology systems 410a, 410b. The lithographic processing system 400a, 400b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 420a, 420b in communication with its respective lithographic processing system 400a, 400b and metrology system 410a, 410b, so that results, designs, data, etc. of the lithographic processing system 400a, 400b and/or the metrology apparatus 410a, 410b may be stored and analyzed by the software application 420a, 420b at the same time or different times.

Once pairs of substrates or wafers are completed from each of lithocell LC1 and lithocell LC2, they may be bonded within a bonding tool 440 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 440 may comprise a bonding alignment device for aligning the wafers together for bonding. For example, the bonding tool 440 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective wafer to be bonded.

In addition to wafer-to-wafer bonding, another known process is die-to-wafer bonding, whereby one or more wafer portions or dies are individually bonded to an acceptor wafer. The concepts disclosed herein are applicable to either or both of wafer-to-wafer bonding and die-to-wafer bonding.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 400a and 400b may comprise different tools or the same tools within each respective system. Similarly metrology apparatuses 410 and 410b may be the same apparatus or different apparatuses. The software application 420a, 420b may be comprised within one or both of the respective lithographic processing systems 400a, 400b and/or one or both of the first metrology systems 410a, 410b, or elsewhere.

As mentioned above, the lithographic processing system 400a, 400b may be configured to include the lithographic apparatus LA in Figure 1. The lithographic processing system 400a, 400b may be setup for executing the patterning aspect of the patterning process and optionally, may be configured to correct for deviations occurring within the lithographic processing system 400a, 400b or in one or more other processes or apparatuses in the patterning process. The lithographic processing system 400a, 400b may be able to apply a correction of an error (e.g., imaging error, focus error, dose error, etc.) by adjusting one or more modification apparatuses of the lithographic processing system 400a, 400b. That is, correction may be made by any manufacturing processing tool in the lithographic processing system 400a, 400b that can purposefully modify a patterning error. In present systems, however, these corrections (scanner corrections and other processing tool corrections) do not take into account any of the bonding processes performed by the bonding tool 440.

For example, the correction of an error can be made by adjusting one or more modification apparatuses of the lithographic apparatus, e.g., by employing the adjustment mechanism AM to correct for or apply an optical aberration, by employing the adjuster AD to correct or modify an illumination intensity distribution, by employing the positioner PM of the patterning device support structure MT and/or the positioner PW of the wafer table WT to correct or modify the position of the patterning device support structure MT and/or the wafer table WT respectively, etc. Where, for example, the lithographic processing system 400a, 400b comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the lithographic processing system 400a, 400b comprises an etch tool, correction of an error can be made by adjusting one or more modification apparatuses of the etch tool, e.g., modifying an etch parameter, such as etchant type, etchant rate, etc. Similarly, where, for example, the lithographic processing system 400a, 400b comprises a planarization tool, correction of an error can be made by adjusting one or more modification apparatuses of the planarization tool, e.g., modifying a planarization parameter. Similarly, where, for example, the lithographic processing system 400a, 400b comprises a deposition tool, correction of an error can be made by adjusting one or more modification apparatuses of the deposition tool, e.g., modifying a deposition parameter.

One or more modification apparatuses of the lithographic processing system 400a, 400b may be able to apply e.g., a higher order polynomial correction of errors (e.g., imaging error, focus error, dose error, etc.). Such a polynomial correction may be second order, third order or higher order.

The metrology apparatus 410a, 410b may be configured to obtain measurements related to wafers printed with patterns by the lithographic processing system 400a, 400b. The metrology apparatus 410a, 410b may be configured to measure or determine one or more parameters (e.g., overlay error, dose, focus, CD, etc.) of the patterns printed by the lithographic processing system 400a, 400b. The metrology apparatus 410a, 410b may be a diffraction-based overlay metrology tool that can measure, e.g., overlay, critical dimension and/or other parameters. The metrology apparatus 410a, 410b may be an alignment apparatus used to measure positional information e.g., relating to in-plane distortion of a wafer. The metrology apparatus 410a, 410b may be a level sensor to measure a position of a surface, e.g., a height and/or rotational position of a wafer surface. The metrology apparatus 410a, 410b may be a plurality of metrology apparatuses including any combination of these devices. The alignment apparatus and/or level sensor may be comprised within the lithographic apparatus and be configured for pre-exposure metrology.

Alternatively or in addition, the metrology apparatus 410a, 410b may comprise a post-exposure metrology device being configured to measure and/or determine one or more values of one or more parameters (e.g., overlay error, CD, focus, dose, etc.) associated with an error in the patterning process after exposure. After the metrology apparatus 410a, 410b finishes the measurement or determination, each software application 420a, 420b determines a respective correction for its corresponding lithographic processing system 400a, 400b based on the measurement data (e.g., overlay error, CD, focus, dose, etc.). The software application 420a, 420b may evaluate the one or more values of the one or more parameters to determine if they are within a tolerance range. If not, the software application 420a, 420b determines the correction to bring these one or more parameters into the tolerance range. The software application 420a, 420b may use one or more mathematical models to model any of the measurement data and/or determine the correction(s).

In particular, each software application 420a, 420b may determine a respective overlay correction to minimize overlay on a respective wafer being exposed on its corresponding lithographic processing system 400a, 400b. Complementary to such corrections, other corrections may be determined within each corresponding lithographic processing system 400a, 400b based, e.g., on leveling and/or alignment metrology performed therein.

The bonding tool 440 and associating bonding alignment device may enable further correction to better align together respective structures of the wafers being bonded together and therefore reduce "bonding overlay". Bonding overlay describes an alignment error of structures on a first wafer (e.g., structures within the top layer/bonding layer of the first wafer, hereafter a first bonding layer) with respect to structures on a second wafer (e.g., structures within the top layer/bonding layer of the second wafer, hereafter a second bonding layer) to which it is to be bonded. This bonding overlay may be equally important to the respective conventional overlays (through-stack overlay) of each of the first and second wafers to the viability of the finished bonded device. The correction potential of the bonding tool may be less than the correction potential of the lithographic processing systems 400a, 400b. For example, the lithographic processing systems may be capable of actuating corrections for higher order polynomial distortion while the bonding tool is only capable of correcting some linear distortion (e.g., limited to corrections by translation, rotation, and magnification of the wafers).

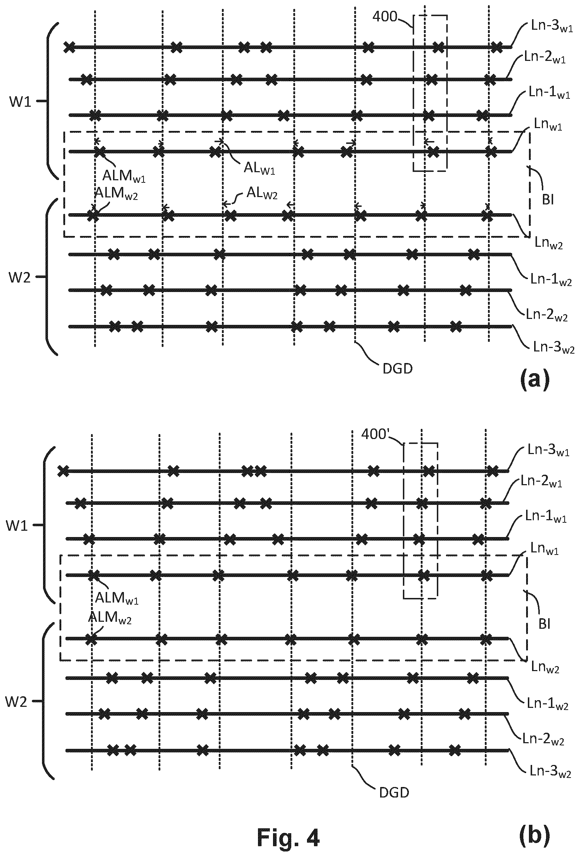

There are a number of drawbacks with the method described in relation to Figure 4. Many of the scanner control methods are unaware of, and therefore do not take into account of, potential bonding steps with other wafers and therefore do not take into account bonding overlay. A method for correcting the alignment model of the top layers prior to bonding has been described in WO2023016791, which is incorporated herein by reference. However, this method may introduce overlay errors with respect to previous layers. In particular, if a large adjustment needs to be made to meet bonding overlay requirements, there may be no solution which balances the on-product overlay (OPO) of the last layer and the bonding overlay such that they are all within specification. The method described in WO2023016791 does not enable the necessary correction to be spread out over multiple layers because it will interact with the process control loop when using indirect alignment (aligning layers to a common lower layer). Additionally, this prior method can only be used to match the average wafer shape of the to be bonded layers and cannot correct for wafer-to-wafer varying shapes, it further requires a significant amount of training wafers on which overlay was measured.

A number of methods will be described, each of which addresses one or more of these issues. The methods may comprise determining a dynamic common grid based on a location of structures at a bonding interface of a bonded substrate and/or obtaining target substrate distortion data associated with a second substrate that is to be bonded to a first substrate to obtain the bonded substrate. The dynamic common grid and/or target substrate distortion data is then used in determining at least a first control action for exposing the first substrate, wherein the control action balances at least first substrate overlay and bonding overlay.

The methods are based on two main concepts. A first proposed concept comprises determining a dynamic common grid for a first wafer and a second wafer which are to be bonded together. The dynamic common grid is determined from the positions of structures on the respective bonding layers (top layers) of the two wafers. In particular, the dynamic common grid is determined from the positions of first bonding layer structures within the first bonding layer (i.e., the bonding layer of the first wafer) and second bonding layer structures within the second bonding layer (i.e., the bonding layer of the second wafer), where the first bonding layer structures and second bonding layer structures are to be aligned together at the bonding interface. A correction (i.e., a precorrection) based on the dynamic common grid can then be determined for exposure of some or all of the layers of one or both wafers to be bonded, which improves the bonding overlay. In this way, the bonding overlay may be brought into specification or (as is more likely) be brought within a correctable range such that the bonding overlay can be brought into specification by application of a bonding correction within the bonding tool. As such, this dynamic common grid is used for referencing control and/or correction of the exposure of the first wafer (i.e., to correct first lithographic apparatus exposure trajectories or a first control action) and exposure of the second wafer (i.e., to correct second lithographic apparatus exposure trajectories or a second control action). The dynamic common grid may also be used for referencing control and/or correction of the bonding process.

Such a method may be implemented as a feedback method, whereby a bonded wafer is initially manufactured without any precorrection and the bonding overlay measured. Based on the measured bonding overlay and/or alignment metrology on the bonded wafer or first and second wafers prior to bonding, the dynamic common grid can be determined and the bonding overlay referenced to this dynamic common grid. The precorrection may comprise at least one bonding layer exposure correction, which is determined with respect to this common grid, for at least one of the first bonding layer and the second bonding layer. The at the least one bonding layer exposure correction may be determined to improve the relative alignment of the bonding layer features which are to be aligned and bonded together and therefore the bonding overlay. The at the least one bonding layer exposure correction may comprise a single correction for only one of the bonding layers (i.e., for only one wafer). However, it may be preferable to distribute the correction over the two bonding layers and therefore the at least one bonding layer exposure correction may comprise a first bonding layer exposure correction for exposure of the first bonding layer of the first wafer and a second bonding layer exposure correction for exposure of the second bonding layer of the second wafer.

Lower layer (through-stack) exposure corrections, which correspond or relate to the bonding layer exposure correction(s), may be determined with respect to the common grid for one or more of the preceding layers on the respective wafer, so as to maintain the overlays of each wafer within the respective specifications for each of these overlays. That is, for each of the wafers (whether one or both) for which a bonding layer exposure correction is applied, corresponding lower layer corrections may also be applied for at least one of the lower layers. The determination of the corrections can account for process requirements (process window) for each layer, e.g., to concentrate such corrections on layers having looser specification requirements. Additionally, the exposure history of each of the wafers (e.g., overlay and/or alignment data for each of the exposed layers) can be used in determining the corrections. In this manner, the overlay between layer for each wafer and the bonding overlay can be balanced. The determination can also take into account the correction capability of the bonding tool, such that errors which can be corrected by the bonding tool can be ignored or given lesser weight than errors (e.g., higher order content) which are uncorrectable during bonding.

Because the proposed method may be implemented as a feedback loop, the common grid may dynamically vary in response to new bonded wafer metrology being performed to obtain bonded overlay data. As such, the dynamic grid may be varied, for example, each lot or even each wafer depending on the regularity of the bonded layer metrology.

The common grid may be determined to minimize the magnitude of the required precorrection. Therefore, by defining the common grid dynamically, based on bonded wafer metrology, it is possible to reduce the magnitude of the precorrections, compared to using a regular common grid.

The bonded wafer metrology data may comprise, for example, dense bonded alignment data. As an alternative, the bonded wafer metrology data may comprise sparser bonded alignment data supplemented with (e.g., dense) bonded overlay data (i.e., measuring the relative alignment of the first and second bonding layers at the bonded interface). The latter example means that less inline alignment metrology is required, as most of the metrology for determining the dynamic grid and the precorrection can be performed offline.

In a specific example, the common grid may be determined from the difference of the bonded alignment data obtained from measuring (post-bonding) the first wafer (i.e., measurement of structures on the first bonding layer at the bonding interface of the bonded wafer) and alignment data obtained from measuring the second wafer (i.e., measurement of structures on the second bonding layer at the bonding interface of the bonded wafer). This bonded alignment data difference may be used alone in the dense alignment case, or in combination with the bonded overlay data in the sparse alignment case.

For example, the bonded alignment data and/or bonded overlay data may describe the positions of the structures which are to be aligned and bonded, and the grid may be defined to be between misaligned structures to be bonded together. As such, respective grid elements of said dynamic common grid may each be defined as being between a first bonding layer structure in the first bonding layer and a second bonding layer structure in the second bonding layer for each of a plurality of pairs of misaligned structures. For example the grid may be defined by each midpoint (e.g., in each of the x and y directions defining the substrate plane) between misaligned structures which are to be bonded together. i.e., the Grid may be determined as:

$$\text{Grid} = \Delta \text{ dense alignment (W1\_Pad, W2\_pad)}$$

in the dense bonded alignment case, where the $\Delta$ dense alignment (W1_Pad, W2_pad)
is the difference between the respective measured positions of the structures to be aligned on the first wafer and second wafer respectively; or

$$\text{Grid} = \Delta \text{ sparse alignment (W1\_Pad, W2\_pad)} + \Delta \text{ dense OVL (W1\_Pad, W2\_pad)}$$

in the sparse bonded alignment and bonded overlay metrology case where $\Delta$ dense OVL (W1_Pad, W2_pad) is the dense overlay data.

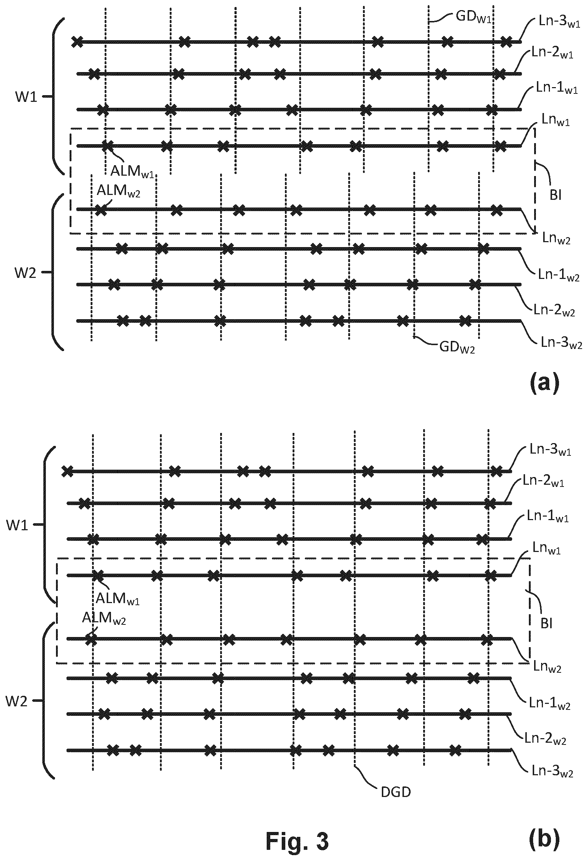

Figure 3(a) illustrates a situation where a first wafer W1 and second wafer W2 are bonded at a bonding interface BI. Each wafer comprises a bonding layer $Ln_{w1}$, $Ln_{w2}$ and multiple (in this case three each) lower layers $Ln\text{-}1_{w1}$, $Ln\text{-}1_{w2}$ $Ln\text{-}2_{w1}$, $Ln\text{-}2_{w2}$ $Ln\text{-}3_{w1}$, $Ln\text{-}3_{w2}$. A number of alignment marks $ALM_{w1}$, $ALM_{w2}$ (only one per layer is labeled) are shown, the alignment marks at the bonding interface BI (i.e., in bonding layers $Ln_{w1}$, $Ln_{w2}$) are each representative of structures which need to be aligned and bonded together; i.e., the labeled alignment marks represent two points which are to be aligned together. In Figure 3(a), a conventional case is shown where each wafer W1, W2 is referenced to a respective different wafer grid $GD_{W1}$, $GD_{W2}$.

Figure 3(b) shows the same arrangement as Figure 3(a), but with a dynamic common grid DGD defined, which is common for the two wafers W1, W2. The grid has been defined with respect to the positions of the structures to be aligned (i.e., the representative alignment marks) at the bonding interface BI, e.g., between each of the respective structures of each pair of structures which are to be aligned. As such, the dynamic common grid DGD may be determined initially from bonding interface metrology BI of a bonded wafer manufactured in a manner illustrated in Figure 3(a), i.e., with respective different wafer grids, or with a standard regular (non-dynamic) common grid.

Figure 4 illustrates the precorrection determination step, based on the example of Figure 3. At Figure 4(a), the respective bonded alignment data $AL_{W1}$, $AL_{W2}$ is measured at the bonding interface BI, i.e., for bonding layers $Ln_{w1}$, $Ln_{w2}$. At step 4(b) a correction is determined for each of the bonding layers $Ln_{w1}$, $Ln_{w2}$ with corresponding corrections to lower layers $Ln-1_{w1}$, $Ln-1_{w2}$ $Ln-2_{w1}$, $Ln-2_{w2}$ $Ln-3_{w1}$, $Ln-3_{w2}$ so as to maintain overlay between all layers. This can be observed, for example, by comparing the alignment marks within box 400 with respect to the common grid DGD before correction and the same alignment marks 400' with respect to the common grid DGD after correction.

It can be appreciated that the structures within the bonding interface BI which are to be aligned together may still be imperfectly or insufficiently aligned subsequent to application of the correction. However, they should be sufficiently aligned such that a bonding correction applied during bonding of the wafer (i.e., for subsequent lots) is able to further align them to within the bonding overlay specification. As such, the correction determination may account for the bonding correction capability of the bonding tool. As such, the correction may be bonding tool dependent or bonding recipe dependent. Alternatively, or in addition, the correction may be product dependent and/or time dependent. The determination of a dynamic common grid mitigates the effects of a large correction being required due to bonding overlay requirements at the bonding interface.

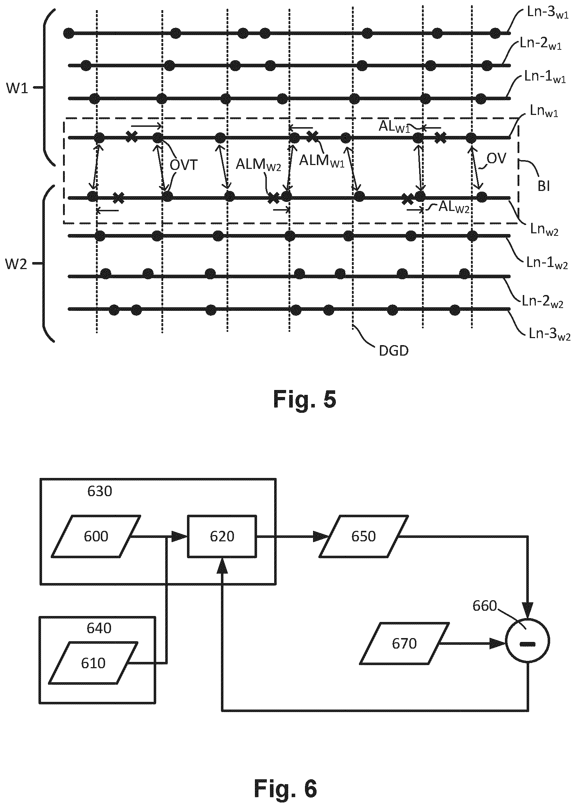

Figure 5 is a diagram of the equivalent arrangement to Figure 4(a), but in the sparse alignment plus overlay metrology example. The dynamic common grid DGD has been determined based on both the respective bonded alignment data $AL_{W1}$, $AL_{W2}$ and bonded overlay data OV measured from the overlay targets OVT measured at the bonding interface BI. The correction can then be determined by measuring respective bonded alignment data $AL_{W1}$, $AL_{W2}$ with respect to the dynamic common grid DGD in combination with the bonded overlay data OV, and determining a correction to improve the bonding overlay while maintain other overlays in specification, as has been described.

A second main concept comprises sending target substrate distortion data or a target wafer shape to a first lithographic apparatus being used to expose a first wafer (e.g., to expose at least a top layer or first bonding layer), the target wafer shape describing the shape and/or distortion of a second wafer to which the first wafer is to be bonded. Therefore, instead of adjusting the alignment model to improve bonding overlay, as is done in the aforementioned WO2023016791, the first lithographic apparatus can use the target wafer shape when calculating corrected expose trajectories (first control action), so as to balance between following the alignment model to minimize OPO, and matching the shape of the bonding layer (and optionally other layers below the bonding layer) being exposed to that of the wafer target shape.

The target wafer shape or target substrate distortion data may be the aforementioned dynamic common grid (i.e., a feedback method), or it can describe the shape and/or distortion of a second wafer to which the first wafer is to be bonded (i.e., a feedforward method).

The target wafer shape may comprise second wafer metrology data such as second wafer alignment data from exposing the bonding layer of the second wafer (second bonding layer). This means that no additional metrology is needed to implement this concept. Furthermore, the proposed correction will follow the wafer-to-wafer and lot-to-lot variation of the second wafer shape.

Figure 6 is a flowchart describing the proposed method at a high level. Alignment data 600 is obtained (e.g., measured) which describes the shape and/or distortion of the first wafer (to be exposed). The target wafer shape data 610 is obtained and used in an exposure optimization 620 for exposing the first wafer. The alignment metrology 600 and optimization may be performed in the first lithographic apparatus 630, i.e., which is being used to expose the first wafer. The target wafer shape data 610 may have been measured within a second lithographic apparatus 640 (i.e., which exposed at least the bonding layer of the second wafer). The target wafer shape data 610 may be attached as a sub-recipe for the optimization 620.

The exposure optimization 620 may determine the exposure settings comprising a correction which balances the OPO (matching the to be exposed layer to the shape of first wafer) and bonding overlay (matching the to be exposed layer to the shape of the second wafer). In doing this, it may account for the OPO specification, the bonding overlay specification and the correction capability of the bonding tool.

For example, if the bonding tool can actuate translation, rotation, magnification (4 parameters), then the 4 parameter shape of the second wafer (i.e., the components/terms of the target wafer shape which can be described by these 4 parameters) can be ignored during this optimization tradeoff.

Residual data 650 which may comprise optimization residual data and actuation residual data may be reported and used in an overlay feedback loop. The optimization residual data may comprise the portion of the first wafer alignment model (first wafer shape) that is not actuated because of the tradeoff with the target shape (second wafer shape). The actuation residual data may comprise the portion of the shapes which cannot be actuated by lens and stages because of limited actuation potential (i.e., the portion of the optimized exposure trajectories which cannot actually be actuated). These residuals are subtracted 660 from on-product metrology or overlay data (feedback metrology data) 670 measured as part of the process control feedback loop to prevent this feedback loop trying to correct these residuals 650 (uncorrectable errors) on subsequent lots. In the case of indirect alignment, the residuals 650 can be fed forward to exposure of the next layer, in the case where the layer being exposed is not the top/bonding layer.

In one example, the optimization may comprise finding exposure setpoints S (lithographic apparatus control parameters) which minimize a combination (e.g., weighted sum) of a (e.g., squared) first substrate overlay (overlay of the first wafer) and the (e.g., squared) bonding overlay ; e.g.,:

$$\min_{S} \frac{(W-S)^2}{opo^2} + \frac{\big((I-H)(V-S)\big)^2}{bopo^2}$$

where $V$ is the target wafer shape (e.g., second wafer bonding layer alignment data), $W$ is the first wafer shape data (first wafer alignment data), $H = M(M'M)^{-1}M'$, where $M$ is a model matrix relating to the correction capability of the bonding tool (e.g., a 4 parameter model matrix) on a dense grid of the full (second) wafer comprising $N$ points and $I$ is an $N \times N$ identity matrix, $opo$ is the overlay specification for the layer being exposed and $bopo$ is the bonding layer overlay specification. It can be appreciated that the $(I - H)$ factor in the second term means that the bonding overlay minimization ignores error contributions which can be corrected within the bonding tool.

An alternative cost function for the optimization step comprises a constrained bonding overlay optimization, which is constrained by the first wafer overlay, e.g.,:

Optimize:

$$\min_{S}\big((I-H)(V-S)\big)^2$$

Constrained by:

$$(W-S)^2 \leq opo^2$$

In this example, the first wafer overlay is guaranteed to be in specification while the bonding overlay is minimized on a best effort basis. The reverse is also possible: i.e., $\min_{S}(W-S)^2$, subject to the constraint $((1-H)(V-S))^2 \leq bopo^2$.

The target wafer shape can be cascaded down in the stack, so as to balance first wafer overlay over multiple layers with the bonding overlay. This will lead to a smaller sacrifice on the first wafer overlay. In the extreme case, the sacrifice is made in the first layer exposed on the wafer. This would mean that the bonding induced wafer shape is introduced without any actual overlay penalties, but instead leads to a distorted wafer grid (i.e., with respect to the true wafer grid of the first wafer). This first layer (distorted grid) shape may be fed-forward throughout the stack, for example similar to an overlay feedforward, so that wafer alignment does not pick up this shape and suffer from aliasing. Taking this to an extreme, the shape of the first layer of the first wafer can be used as a target wafer shape for the first layer of second wafer; this latter shape in turn may be used as the target shape for the second layer of the first wafer, which can then be used as the target shape for the second layer of second wafer and so on. In this manner, matching of the wafer shapes occurs by design and the penalty on OPO for each layer will be small.

The proposed methods may be combined. For example, the wafer shapes/distortion data of this second concept may be referenced to a dynamic common grid determined in accordance with the first concept.

This second concept is more broadly applicable to applications other than improving wafer bonding overlay for bonded wafers. The concept is applicable more generally to take into account limitations in actuation capabilities of manufacturing apparatuses used to expose and/or process different layers on a (single or bonded) wafer.

For example, different scanners have different actuation potential. As such, the target wafer shape may be determined from an error that is introduced by the top layer lithographic apparatus which cannot be corrected within the top layer lithographic apparatus.

In such a case, the target wafer shape $V$, sent to a first lithographic apparatus with which a first layer is to be exposed and which has a first actuation capability, may comprise the known non-correctable fingerprint of a second lithographic apparatus with which a second layer is to be exposed on the same wafer, and which has a second actuation capability. $W$ may comprise the first layer shape data. In a basic implementation, instead of the low order actuation potential of the bonder tool, the second actuation capability of the second lithographic apparatus may be represented by model matrix $M$ (i.e., the projection onto the space of actuatable shapes expressed by $H$ in either of the weighted sum or constrained version of the cost function above). Such an implementation may be used when there is a certain shape (e.g., a k-parameter) that the second apparatus cannot actuate at all. Where the second apparatus can actuate the particular shape, but with a smaller range than the apparatus of the first layer, this may be captured by appropriate adaption of the formulas/cost function.

Additionally, one machine may have a known fingerprint/shape that it cannot correct which another machine is able to actuate. Examples of such known fingerprints are the slit fingerprint on some EUV scanners. Also, for post bonding lithography, the average fingerprint of the bonding step may be injected (e.g., removed/subtracted in a feedback mechanism) such that the shape during post bonding lithography is smaller and easier to actuate. Additionally, shapes introduced by other processes and processing tools (manufacturing apparatuses other than lithographic apparatuses) after the current layer, but before the top layer (e.g., deposition, CMP) may be subtracted in this way. To address this, during actuation of the first layer, shapes that second layer scanner cannot actuate may be partially ignored.

In this case, the target wafer shape $V$, sent to a first lithographic apparatus with which a first layer is to be exposed and which has a first actuation capability, may comprise the first layer shape data $W$ with the uncorrectable shape (e.g., slit fingerprint, bonding fingerprint etc.) subtracted.

The first layer may be a lower layer (the bottom layer of an overlay layer pair) and the second layer may be an upper layer (the top layer of an overlay layer pair). An overlay layer pair may describe a pair of layers on a wafer between which overlay is measured and controlled. "First"/"top" and "second"/"bottom" should not be necessarily meant to describe an absolute position in the stack, but rather these layer positions relative to one another. In other words, the first/bottom layer does not necessarily need to be the very first or bottom layer exposed (although it may be), and the second/top layer is not necessarily the second nor the topmost layer in the stack (although it may be either or both of these). There may or may not be one or more other layers between the first layer and second layer.

In this manner, the first layer lithographic apparatus will utilize its actuation potential to deliberately inject the non-correctable fingerprint of the second lithographic apparatus onto the wafer, and to partially ignore shapes present on the wafer that the second lithographic apparatus is unable to actuate, all while ensuring that the present layer OPO is in specification. This way overlay of the next layer towards the current layer will improve.

Further embodiments of the invention are disclosed in the list of numbered clauses below:

1. A method of configuring at least a first lithographic apparatus for performing a first lithographic process on at least a first substrate which is to be bonded to a second substrate to obtain a bonded substrate, the method comprising: determining a dynamic common grid based on a location of structures at a bonding interface of the bonded substrate, the dynamic common grid comprising a control grid which is common for said first lithographic process and a second lithographic process on the second substrate prior to said bonding; and/or obtaining target substrate distortion data associated with the second substrate that is to be bonded to the first substrate or which comprises said dynamic common grid; and using said dynamic common grid and/or said target substrate distortion data in determining at least a first control action for performing at least the first lithographic process, wherein the control action balances at least first substrate overlay relating at least to a misalignment between a first bonding layer of the first substrate and at least one previous layer of the first substrate and bonding overlay relating to a misalignment between the first bonding layer and a second bonding layer on the second substrate after bonding of the first substrate to the second substrate.

2. A method according to clause 1, comprising said determining the dynamic common grid and using the dynamic common grid to determine a correction; wherein the method comprises determining at least a first substrate overlay correction to at least partially correct said first substrate overlay, said first substrate overlay correction being referenced to said dynamic common grid.

3. A method according to clause 2, wherein said method further comprises determining a bonding correction, referenced to the dynamic common grid, for application within a bonding tool used to bond the first substrate and second substrate, wherein the bonding correction further corrects the bonding overlay.

4. A method according to clause 2 or 3, wherein respective grid elements of said dynamic common grid are each defined as being between a first bonding layer structure in the first bonding layer and a second bonding layer structure in the second bonding layer for each of a plurality of pairs of misaligned structures.

5. A method according to clause 4, wherein said respective grid elements of said dynamic common grid are each defined as being at a midpoint between the first bonding layer structure and second bonding layer structure of each pair of misaligned structures.

6. A method according to any of clauses 2 to 5, wherein the dynamic common grid is determined in a feedback loop based on bonded substrate metrology data measured from previously manufactured examples of said bonded substrate and/or metrology data measured from said first substrate and second prior to bonding.

7. A method according to clause 6, wherein said bonded substrate metrology data comprises bonded alignment data of said first bonding layer and said second bonding layer of the bonded substrate.

8. A method according to clause 7, wherein said dynamic common grid is determined, at least in part, from the difference of the bonded alignment data relating to the first substrate and said bonded alignment data relating to the second substrate.

9. A method according to any of clauses 6 to 8, wherein said bonded substrate metrology data further comprises bonded overlay data of the bonded substrate.

10. A method according to any of clauses 2 to 9, wherein said first substrate overlay correction comprises correction for overlay for said one or more other layers below the first bonding layer on said first substrate.

11. A method according to any of clauses 2 to 10, comprising using said dynamic common grid to determine a second control action for performing a second lithographic process on the second substrate, wherein the control action balances said first substrate overlay, said bonding overlay and a second substrate overlay relating at least to a misalignment between the second bonding layer and at least one previous layer of the second substrate.

12. A method according to clause 11, wherein the method comprises determining at least a second substrate overlay correction to at least partially correct said second substrate overlay, said second substrate overlay correction being referenced to said dynamic common grid.

13. A method according to clause 12, wherein said second substrate overlay correction comprises correction for overlay for said one or more other layers below the second bonding layer on said second substrate.

14. A method according to any of clauses 11 to 13, wherein said dynamic common grid is determined to minimize the magnitude of the first substrate overlay correction and/or second substrate overlay substrate correction.

15. A method according to any of clauses 2 to 13, wherein said dynamic common grid is determined to minimize the magnitude of at least the first substrate overlay correction.

16. A method according to any preceding clause, wherein said method comprises said obtaining target substrate distortion data; and using said target substrate distortion data to determine the first control action.

17. A method according to clause 16, wherein said target substrate distortion data comprises at least and/or is referenced to said dynamic common grid based on the location of structures at a bonding interface of the bonded substrate.

18. A method according to clause 16 or 17, wherein said target substrate distortion data comprises at least alignment data relating to exposure of at least the second bonding layer.

19. A method according to clause 16, 17 or 18, wherein said determining the first control action comprises minimizing at least the bonding overlay.

20. A method according to clause 19, wherein said minimizing the bonding overlay is such that error contributions which can be corrected within the bonding tool are ignored.

21. A method according to any of clauses 16 to 20, wherein said determining the first control action comprises minimizing a combination of the first substrate overlay and bonding overlay.

22. A method according to clause 21, wherein said combination comprises a weighted sum of the first substrate overlay and bonding overlay or the squared first substrate overlay and squared bonding overlay.

23. A method according to clause 22, wherein a weighting of the weighted sum is based at least on a first substrate overlay specification for the first substrate overlay and a bonding overlay specification for the bonding overlay.

24. A method according to any of clauses 16 to 20, wherein said determining the first control action comprises minimizing the bonding overlay, subject to a constraint which ensures that the first substrate overlay is within a first substrate overlay specification.

25. A method according to any of clauses 16 to 24, comprising determining residual data comprising one or both of optimization residual data and/or actuation residual data and removing the residual data from feedback metrology data describing said first substrate overlay and/or bonding overlay.

26. A method according to any preceding clause, wherein said at least a first control action results in a bonding overlay which can be brought into specification by application of a bonding correction within a bonding tool used to bond the first substrate and second substrate.

27. A method according to any preceding clause, wherein the step of determining said at least the first control action comprises determining said at least the first control action based on a correction capability of the bonding tool.

28. A method according to any preceding clause, wherein the step of determining said at least the first control action comprises determining said at least the first control action based on one or more of: a first substrate overlay specification describing a specification for one or more layers of said first substrate; a second substrate overlay specification describing a specification for one or more layers of said second substrate; and/or a bonding overlay specification for the bonding overlay.

29. A method according to any preceding clause, comprising performing said at least the first lithographic process in accordance with said first control action to obtain said first substrate.

30. A method according to clause 29, comprising bonding said first substrate to said second substrate to obtain a bonded substrate.

31. A method of configuring at least a first manufacturing apparatus for exposing a first layer on a substrate, onto which at least a second layer is to be exposed using a second manufacturing apparatus, the first manufacturing apparatus having a first actuation capability and the second first manufacturing apparatus having a second actuation capability, the method comprising: obtaining target substrate distortion data describing distortion which cannot be corrected or can be only partially corrected with the second actuation capability; and determining at least a first control action for exposing the first layer using said target substrate distortion data.

32. A method according to clause 31, wherein said step of determining at least a first control action comprises determining the control action to follow or remove said target substrate distortion data, constrained by maintaining a first layer overlay within specification.

33. A method according to clause 31 or 32, wherein said step of determining at least a first control action comprises deliberately injecting or subtracting a shape described by said target substrate distortion data onto the substrate.

34. A method according to any of clauses 31 to 33, wherein said determining at least a first control action comprises at least partially ignoring shapes present in the substrate which cannot be corrected or can be only partially corrected with the second actuation capability.

35. A method according to any of clauses 31 to 34, wherein the second actuation capability is more limited than the first actuation capability.

36. A computer program comprising program instructions operable to perform the method of any preceding clause, when run on a suitable apparatus.

37. A non-transient computer program carrier comprising the computer program of clause 36.

38. A processing arrangement comprising: the non-transient computer program carrier of clause 37; and a processor operable to run the computer program comprised on said non-transient computer program carrier.

39. A lithographic apparatus comprising: an alignment sensor; a patterning device support for supporting a patterning device; a substrate support for supporting a substrate; and the processing arrangement of clause 38.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of configuring at least a first lithographic apparatus for performing a first lithographic process on at least a first substrate which is to be bonded to a second substrate to obtain a bonded substrate, the method comprising:

   determining a dynamic common grid based on a location of structures at a bonding interface of the bonded substrate, the dynamic common grid comprising a control grid which is common for said first lithographic process and a second lithographic process on the second substrate prior to said bonding; and/or obtaining target substrate distortion data associated with the second substrate that is to be bonded to the first substrate or which comprises said dynamic common grid; and
   using said dynamic common grid and/or said target substrate distortion data in determining at least a first control action for performing at least the first lithographic process, wherein the control action balances at least first substrate overlay relating at least to a misalignment between a first bonding layer of the first substrate and at least one previous layer of the first substrate and bonding overlay relating to a misalignment between the first bonding layer and a second bonding layer on the second substrate after bonding of the first substrate to the second substrate.

2. A method as claimed in claim 1, comprising said determining the dynamic common grid and using the dynamic common grid to determine a correction; wherein the method comprises determining at least a first substrate overlay correction to at least partially correct said first substrate overlay, said first substrate overlay correction being referenced to said dynamic common grid.

3. A method as claimed in claim 2, wherein said method further comprises determining a bonding correction, referenced to the dynamic common grid, for application within a bonding tool used to bond the first substrate and second substrate, wherein the bonding correction further corrects the bonding overlay.

4. A method as claimed in claim 2 or 3, wherein respective grid elements of said dynamic common grid are each defined as being between a first bonding layer structure in the first bonding layer and a second bonding layer structure in the second bonding layer for each of a plurality of pairs of misaligned structures.

5. A method as claimed in claim 4, wherein said respective grid elements of said dynamic common grid are each defined as being at a midpoint between the first bonding layer structure and second bonding layer structure of each pair of misaligned structures.

6. A method as claimed in claim 2, wherein the dynamic common grid is determined in a feedback loop based on bonded substrate metrology data measured from previously manufactured examples of said bonded substrate and/or metrology data measured from said first substrate and second prior to bonding.

7. A method as claimed in claim 6, wherein said bonded substrate metrology data comprises bonded alignment data of said first bonding layer and said second bonding layer of the bonded substrate.

8. A method as claimed in claim 2, comprising using said dynamic common grid to determine a second control action for performing a second lithographic process on the second substrate, wherein the control action balances said first substrate overlay, said bonding overlay and a second substrate overlay relating at least to a misalignment between the second bonding layer and at least one previous layer of the second substrate.

9. A method as claimed in claim 8, wherein the method comprises determining at least a second substrate overlay correction to at least partially correct said second substrate overlay, said second substrate overlay correction being referenced to said dynamic common grid.

10. A method as claimed in claim 9, wherein said dynamic common grid is determined to minimize the magnitude of the first substrate overlay correction and/or second substrate overlay substrate correction.

11. A method as claimed in claim 1, wherein said at least a first control action results in a bonding overlay which can be brought into specification by application of a bonding correction within a bonding tool used to bond the first substrate and second substrate.

12. A method as claimed in claim 1, wherein the step of determining said at least the first control action comprises determining said at least the first control action based on a correction capability of the bonding tool.

13. A method as claimed in claim 1, wherein the step of determining said at least the first control action comprises determining said at least the first control action based on one or more of:

   a first substrate overlay specification describing a specification for one or more layers of said first substrate;
   a second substrate overlay specification describing a specification for one or more layers of said second substrate; and/or
   a bonding overlay specification for the bonding overlay.

14. A method as claimed in claim 1, comprising performing said at least the first lithographic process in accordance with said first control action to obtain said first substrate and/or bonding said first substrate to said second substrate to obtain a bonded substrate.

15. A computer program comprising program instructions operable to perform the method of claim 1, when run on a suitable apparatus.

Fig. 1

Fig. 2

**Fig. 3**

**Fig. 4**

**Fig. 5**

**Fig. 6**

# EP 4 760 391 A1

Europäisches
Patentamt
European
Patent Office
Office européen
des brevets

## EUROPEAN SEARCH REPORT

**Application Number**

EP 24 22 0110

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 768 441 B2 (ASML NETHERLANDS BV [NL]) 26 September 2023 (2023-09-26) * column 3, line 1 - column 16, line 44 * * figure 4 * ----- | 1-15 | INV. G03F7/00 |
| A | US 2023/030116 A1 (ZACH FRANZ [US] ET AL) 2 February 2023 (2023-02-02) * the whole document * ----- | 1,15 | |

**TECHNICAL FIELDS SEARCHED (IPC)**

G03F

The present search report has been drawn up for all claims

| Place of search | Date of completion of the search | Examiner |
|---|---|---|
| Munich | 23 June 2025 | Meixner, Matthias |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 0110

This annex lists the patent family members relating to the patent documents cited in  the above-mentioned European search report.
The members are as contained in the European Patent Office EDP file on
The European Patent Office is in no way liable for these particulars which are merely given for the purpose of information.

23-06-2025

| Patent document cited in search report | | Publication date | Patent family member(s) | | Publication date |
|---|---|---|---|---|---|
| US 11768441 | B2 | 26-09-2023 | CN | 115244467 A | 25-10-2022 |
| | | | JP | 7312917 B2 | 21-07-2023 |
| | | | JP | 2023515790 A | 14-04-2023 |
| | | | KR | 20220137074 A | 11-10-2022 |
| | | | US | 2023108481 A1 | 06-04-2023 |
| | | | US | 2024045340 A1 | 08-02-2024 |
| | | | WO | 2021175527 A1 | 10-09-2021 |
| US 2023030116 | A1 | 02-02-2023 | CN | 117425954 A | 19-01-2024 |
| | | | EP | 4324022 A1 | 21-02-2024 |
| | | | JP | 2024529824 A | 14-08-2024 |
| | | | KR | 20240039090 A | 26-03-2024 |
| | | | TW | 202312306 A | 16-03-2023 |
| | | | US | 2023030116 A1 | 02-02-2023 |
| | | | WO | 2023009563 A1 | 02-02-2023 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- WO 2023016791 A